# EUROPÄISCHE PATENTANMELDUNG

(11) **EP 4 379 409 A1**
(43) Veröffentlichungstag der Anmeldung: **05.06.2024**
(21) Anmeldenummer: 22211132.0
(22) Anmeldetag: 02.12.2022
(51) Int. Cl.: G01R 33/54, G01R 33/56

(54) **STEUEREINHEIT, VERFAHREN ZUM BETREIBEN EINER STEUEREINHEIT, MRT-VORRICHTUNG UMFASSEND EINE STEUEREINHEIT, COMPUTERPROGRAMM UND ELEKTRONISCH LESBARER DATENTRÄGER**

(71) Anmelder: Siemens Healthineers AG, 91301 Forchheim (DE)
(72) Erfinder: Liu, Wei, 91052 Erlangen (DE); Maier, Florian, 91054 Buckenhof (DE); Meyer, Heiko, 91080 Uttenreuth (DE); Splitthoff, Daniel Nicolas, 91080 Uttenreuth (DE); Vahle, Thomas, 90409 Nürnberg (DE)
(74) Vertreter: Siemens Healthineers Patent Attorneys

(57) **Zusammenfassung**

Die Erfindung betrifft eine Steuereinheit (5).

Es ist vorgesehen, dass die Steuereinheit (5) dazu eingerichtet ist, eine Bereitstellungsanfrage (13) zur Bereitstellung einer MRT-Abbildung (7) eines geometrischen Abbildungsbereiches (11) eines Objektes (3) zu empfangen, wobei die Bereitstellungsanfrage (13) eine Vorgabe betreffend zumindest ein zwischen einer MRT-Referenzabbildung (20) des Abbildungsbereichs (11) und der MRT-Abbildung (7) abzugleichendes Merkmal (12) umfasst. Die Steuereinheit (5) ist dazu eingerichtet, nach einem vorgegebenen Messverfahren eine MRT-Vorrichtung (1) gemäß der Vorgabe zur Durchführung einer vorgegebenen MRT-Messung zumindest an dem geometrischen Abbildungsbereich (11) des Objekt (3) anzusteuern, und einen in der Messung generierten MRT-Datensatz (6) zu empfangen. Die Steuereinheit (5) ist dazu eingerichtet, nach einem vorgegebenen Exportierungsverfahren aus dem MRT-Datensatz (6) die MRT-Abbildung (7) des geometrischen Abbildungsbereiches (11) des Objektes (3) gemäß der zumindest einen Vorgabe bereitzustellen.

## Beschreibung

Unabhängig vom grammatikalischen Geschlecht eines bestimmten Begriffes sind Personen mit männlicher, weiblicher oder anderer Geschlechteridentität mit umfasst.

Die vorliegende Erfindung betrifft eine Steuereinheit, ein Verfahren zum Betreiben einer Steuereinheit sowie eine MRT-Vorrichtung umfassend eine Steuereinheit. Die Erfindung ist ferner auf ein entsprechendes Computerprogramm und einen elektronisch lesbaren Datenträger gerichtet.

Eine konsistente Bildgebung bei der Untersuchung verschiedener Objekte mittels bildgebender Verfahren, wie beispielsweise der Magnetresonanztomografie, ist für eine hochwertige Diagnose von Vorteil. Dies trifft auch auf eine an einem Objekt durchgeführte Folge mehrerer Untersuchungen mittels Magnetresonanztomografie zu. MRT-Untersuchungen erfolgen dabei nach einem jeweiligen vorgegebenen MRT-Protokoll.

In der Medizin kann es sich bei dem zu untersuchendem Objekt beispielsweise um einen Patienten handeln. Eine höchste Konsistenz bei der Bildgebung ergäbe sich bei einer Durchführung der MRT-Untersuchungen nach gleichen MRT-Protokollen. Allerdings sind MRT-Protokolländerungen zwischen MRT-Routineuntersuchungen aufgrund verschiedener klinischer Anforderungen der jeweiligen MRT-Routineuntersuchung und der Individualität der Patienten üblich. Außerdem können MRT-Abbildungen der jeweiligen MRT-Routineuntersuchungen erheblich voneinander abweichen. Dies kann beispielsweise von einer Lage des Patienten in der MRT-Vorrichtung während der jeweiligen MRT-Routineuntersuchung, einem Gerätemodell der MRT-Vorrichtung oder einer während der MRT-Routineuntersuchung angewandten Technik abhängen.

Automatisierte Arbeitsabläufe zur Durchführung von MRT-Untersuchungen nach dem Stand der Technik ermöglichen eine einfache Anpassung von Parametern eines MRT-Protokolls einer MRT-Untersuchung in Abhängigkeit von einem Zustand des Patienten oder von klinischen Anforderungen. Dabei ermöglichen automatisierte Arbeitsabläufe eine Bereitstellung von konsistenteren und reproduzierbaren Ergebnissen. Im Vergleich zu einem manuell eingestellten MRT-Protokoll zur Durchführung einer MRT-Untersuchung können die automatisierten Arbeitsabläufe eine Bildqualität der MRT-Abbildungen sicherstellen, die für MRT-Untersuchungen in verschiedenen Regionen bereits gut bewertet wurde.

Darüber hinaus haben auch die Fähigkeiten eines Bedieners der MRT-Vorrichtung oder die Mitarbeit des Patienten einen großen Einfluss auf die resultierenden MRT-Abbildungen. Die MRT-Abbildung kann beispielsweise durch eine unregelmäßige Atmung, Herzrhythmusstörungen und Bewegungen des Patienten während der MRT-Messung beeinträchtigt werden.

Eine automatische Ausrichtung verschiedener MRT-Abbildungen Anhand anatomischer Strukturen ist ein wichtiger Schritt für eine MRT-basierte Gruppenanalyse. Zum Beispiel erfordert die voxelbasierte Analyse der Hirnmorphologie in der Regel eine hochgenaue Bildregistrierung der jeweiligen MRT-Abbildungen. Darüber hinaus ist auch eine Qualitätskontrolle (QC) wichtig, um eine erfolgreiche Ausrichtung der MRT-Abbildungen aus verschiedenen MRT-Messungen zu gewährleisten.

In der Veröffentlichung von Benhajali et al. 2020 (Yassine Benhajali et al. A Standardized Protocal for Efficient and Reliable Quality Control of Brain Registration in Functional MRI Studies. Frontiers in Neuroinformatics, 2020) wird ein standardisiertes Verfahren für die visuelle Qualitätskontrolle der Hirnregistrierung vorgeschlagen und anhand der Zuverlässigkeit der QC-Bewertungen evaluiert. Eine Registrierung zwischen verschiedenen MRT-Abbildungen erfolgt offline durch ein spezielles Hirnregistrierungstool in Kombination mit einer visuellen QC-Prüfung. Es wurde nachgewiesen, dass eine mangelnde Robustheit der Registrierung hauptsächlich auf Unterschiede in der Bildqualität, der Form und der kortikalen Topologie zwischen den MRT-Abbildungen der einzelnen Gehirne zurückzuführen ist.

Eine visuelle Überprüfung der MRT-Abbildungen, um eine robuste Registrierung der MRT-Abbildungen sicherzustellen, ist jedoch in der Regel mühsam und zeitaufwändig. Zudem hängt eine Genauigkeit der visuellen Überprüfung der MRT-Abbildungen von dem durchführenden Prüfer ab.

Es ist eine Aufgabe der vorliegenden Erfindung, eine Bereitstellung von MRT-Abbildungen für eine Registrierung zu optimieren.

Diese Aufgabe wird durch den jeweiligen Gegenstand der unabhängigen Ansprüche gelöst. Vorteilhafte Weiterbildungen und weitere Ausführungsformen sind Gegenstand der abhängigen Ansprüche.

Ein erster Aspekt der Erfindung betrifft eine Steuereinheit.

Die Steuereinheit ist dazu eingerichtet, eine Bereitstellungsanfrage zur Bereitstellung einer MRT-Abbildung eines geometrischen Abbildungsbereiches eines Objektes zu empfangen, wobei die Bereitstellungsanfrage eine Vorgabe betreffend zumindest ein zwischen einer MRT-Referenzabbildung und der MRT-Abbildung abzugleichendes Merkmal umfasst. Mit anderen Worten ist die Steuereinheit zur Annahme der Bereitstellungsanfrage vorgesehen. Die Steuereinheit kann beispielsweise eine Schnittstelle und/oder eine Benutzereingabevorrichtung zur Entgegennahme der Bereitstellungsanfrage aufweisen. Die Bereitstellungsanfrage ist dazu vorgesehen, eine Bereitstellung der MRT-Abbildung durch die Steuereinheit einzuleiten, wobei die MRT-Referenzabbildung als Referenz oder Vorlage für die MRT-Abbildung verwendet wird. Die bereitzustellende MRT-Abbildung soll dabei den geometrischen Abbildungsbereich des Objektes abbilden, welcher in der MRT-Referenzabbildung abgebildet ist. Es kann somit vorgesehen sein, dass eine MRT-Vorrichtung durch die Steuereinheit derart anzusteuern ist, dass die MRT-Aufnahme den gleichen Abbildungsbereich des Objektes abbildet, wie die MRT-Referenzabbildung.

Ein mehrmaliges Erfassen des gleichen Abbildungsbereiches kann vorgesehen sein, um MRT-Abbildungen bereitzustellen, welche in MRT-Untersuchungen nach unterschiedlichen MRT-Protokollen erzeugt werden. Somit können beispielsweise in der MRT-Abbildung andere Informationen dargestellt sein als in der MRT-Referenzabbildung. Es kann auch vorgesehen sein, dass der gleiche Abbildungsbereich nach einem MRT-Protokoll untersucht wird, welches identisch mit dem MRT-Protokoll ist, welches zur Erfassung der MRT-Referenzabbildung verwendet wurde. Dies kann beispielsweise vorgesehen sein, wenn eine zeitliche Veränderung des Abbildungsbereiches zu untersuchen ist.

Die Bereitstellungsanfrage zur Bereitstellung der MRT-Abbildung umfasst eine Vorgabe betreffend zumindest ein zwischen der MRT-Referenzabbildung des Abbildungsbereiches und der MRT-Abbildung abzugleichendes Merkmal. Bei dem abzugleichenden Merkmal kann es sich um einen Parameter der MRT-Abbildung handeln, welcher identisch oder möglichst ähnlich mit dem entsprechenden Merkmal der MRT-Referenzabbildung sein soll. Die Steuereinheit wird somit durch die Bereitstellungsanfrage dazu angewiesen, die MRT-Abbildungen bereitzustellen, welche einen gleichen Abbildungsbereich des Objektes zeigt wie die MRT-Referenzabbildung. Zugleich wird die Steuereinheit durch die Bereitstellungsanfrage dazu angewiesen, das Merkmal der MRT-Abbildung mit dem Merkmal der MRT-Referenzabbildung abzugleichen. Unter dem Abgleichen kann verstanden werden, dass die MRT-Abbildung der Art bereitzustellen ist, dass das Merkmal der MRT-Abbildung mit dem Merkmal der MRT-Referenzabbildung übereinstimmt oder einen kleinstmöglichen Unterschied zu dem Merkmal der MRT-Referenzabbildung aufweist. Das abzugleichende Merkmal kann beispielsweise eine Ortsauflösung der MRT-Abbildung betreffen. Es kann in diesem Fall beispielsweise vorgesehen sein, dass die Ortsauflösung, welche die MRT-Abbildung aufweisen soll, mit der Ortsauflösung der MRT-Referenzabbildung abzugleichen ist, sodass die Ortsauflösungen übereinstimmen oder möglichst ähnlich sind.

Die MRT-Referenzabbildung bildet den geometrischen Abbildungsbereich des Objektes ab. Die MRT-Referenzabbildung kann eine MRT-Abbildung sein, die aus einem MRT-Referenzdatensatz erzeugt sein kann. Der MRT-Referenzdatensatz kann in einer an dem Objekt durch eine MRT-Vorrichtung durchgeführten MRT-Untersuchung erzeugt sein. Die MRT-Untersuchung kann nach einem bestimmten MRT-Protokoll durchgeführt sein. Die MRT-Abbildung kann eine zweidimensionale oder dreidimensionale Abbildung des geometrischen Abbildungsbereiches des Objektes sein. Der Abbildungsbereich kann beispielsweise eine vorgegebene Fläche oder ein vorgegebenes Volumen des Objektes sein. Der Abbildungsbereich kann auch ein auf eine Anatomie oder Struktur des Objektes bezogener örtlicher Abbildungsbereich sein.

Die Steuereinheit ist dazu eingerichtet, nach einem vorgegebenen Messverfahren eine MRT-Vorrichtung gemäß der zumindest einen Vorgabe anzusteuern. Die Ansteuerung erfolgt, um zumindest an dem geometrischen Abbildungsbereich des Objekts eine vorgegebene MRT-Messung durchzuführen. Die MRT-Messung kann nach einem MRT-Protokoll erfolgen, welches für die MRT-Abbildung vorgegeben sein kann. Das MRT-Protokoll zur Generierung der MRT-Abbildung kann sich von dem MRT-Protokoll, nach dem die MRT-Referenzabbildung erzeugt wurde, unterscheiden oder mit diesem identisch sein. Die Steuereinheit ist dazu eingerichtet, einen in der MRT-Messung durch die MRT-Vorrichtung generierten MRT-Datensatz zu empfangen. Mit anderen Worten ist die Steuereinheit dazu eingerichtet, die MRT-Vorrichtung anzusteuern, damit diese die vorgegebene MRT-Messung an dem Objekt durchführt. Die Steuereinheit ist dazu eingerichtet, die MRT-Vorrichtung derart anzusteuern, dass diese zumindest den geometrischen Abbildungsbereich des Objektes in der vorgegebenen MRT-Messung erfasst. Die Steuereinheit kann beispielsweise dazu eingerichtet sein, einen Prescan des Objektes durchzuführen, um eine Vorabaufnahme des Objektes zu erzeugen. Die Steuereinheit kann dazu eingerichtet sein, die Vorabaufnahme zu untersuchen, um den Abbildungsbereich in der Vorabaufnahme zu lokalisieren und die MRT-Vorrichtung zur Erfassung des lokalisierten Abbildungsbereiches anzusteuern. Handelt es sich bei der MRT-Referenzabbildung beispielsweise um eine zweidimensionale Abbildung und bei dem Prescan um eine dreidimensionale Vorabaufnahme des Objektes kann die Steuereinheit beispielsweise eine Ebene in der dreidimensionalen Vorabaufnahme identifizieren, welche eine größtmögliche Übereinstimmung mit der MRT-Referenzabbildung aufweist. Die Steuereinheit kann die MRT-Vorrichtung in Abhängigkeit von der Vorgabe ansteuern. Dies kann bedeuten, dass der besagte geometrischen Abbildungsbereich derart durch die MRT-Vorrichtung in dem MRT-Messverfahren erfasst, wird, dass der geometrischen Abbildungsbereich mit derselben Ortsauflösung erfasst wird, welche die MRT-Referenzabbildung aufweist, oder mit einer Ortsauflösung, welche eine Bereitstellung der MRT-Abbildung mit der Ortsauflösung ermöglicht. Die Während der Messung erfassten MRT-Daten können in einem MRT-Datensatz durch die MRT-Vorrichtung bereitgestellt und von der Steuereinheit empfangen werden.

Die Steuereinheit ist dazu eingerichtet, nach einem vorgegebenen Exportierungsverfahren aus dem MRT-Datensatz die MRT-Abbildung des geometrischen Abbildungsbereiches des Objektes gemäß der zumindest einen Vorgabe bereitzustellen. Mit anderen Worten ist die Steuereinheit dazu vorgesehen, den MRT-Datensatz auszuwerten, um die MRT-Abbildung aus dem MRT-Datensatz zu erzeugen. Das Exportierungsverfahren erfolgt gemäß der Vorgabe an die MRT-Abbildung. Es kann beispielsweise vorgesehen sein, dass die Ortsauflösung, mit welcher der Abbildungsbereich erfasst wurde, um ein ganzzahliges Vielfaches größer ist als die Ortsauflösung gemäß der Vorgabe. In dem Exportierungsverfahren kann die Ortsauflösung entsprechend reduziert werden, sodass die Ortsauflösung der MRT-Abbildung mit der Ortsauflösung der MRT-Referenzabbildung übereinstimmt.

Durch die Erfindung ergibt sich der Vorteil, dass eine MRT-Abbildung bereitgestellt werden kann, welche ein Merkmal aufweist, das mit einer MRT-Referenzabbildung abgestimmt ist. Somit kann die MRT-Abbildung für ein Registrierungsverfahren optimiert werden.

Die Steuereinheit kann zumindest eine Recheneinheit umfassen.

Unter einer Recheneinheit kann insbesondere ein Datenverarbeitungsgerät verstanden werden, das einen Verarbeitungsschaltkreis enthält. Die Recheneinheit kann also insbesondere Daten zur Durchführung von Rechenoperationen verarbeiten. Darunter fallen gegebenenfalls auch Operationen, um indizierte Zugriffe auf eine Datenstruktur, beispielsweise eine Umsetzungstabelle, LUT (englisch: "look-up table"), durchzuführen.

Die Recheneinheit kann insbesondere einen oder mehrere Computer, einen oder mehrere Mikrocontroller und/oder einen oder mehrere integrierte Schaltkreise enthalten, beispielsweise eine oder mehrere anwendungsspezifische integrierte Schaltungen, ASIC (englisch: "applicationspecific integrated circuit"), eines oder mehrere feldprogrammierbare Gate-Arrays, FPGA, und/oder eines oder mehrere Einchipsysteme, SoC (englisch: "system on a chip"). Die Recheneinheit kann auch einen oder mehrere Prozessoren, beispielsweise einen oder mehrere Mikroprozessoren, eine oder mehrere zentrale Prozessoreinheiten, CPU (englisch: "central processing unit"), eine oder mehrere Grafikprozessoreinheiten, GPU (englisch: "graphics processing unit") und/oder einen oder mehrere Signalprozessoren, insbesondere einen oder mehrere Digitalsignalprozessoren, DSP, enthalten. Die Recheneinheit kann auch einen physischen oder einen virtuellen Verbund von Computern oder sonstigen der genannten Einheiten beinhalten.

In verschiedenen Ausführungsbeispielen beinhaltet die Recheneinheit eine oder mehrere Hardware- und/oder Softwareschnittstellen und/oder eine oder mehrere Speichereinheiten.

Eine Speichereinheit kann als flüchtiger Datenspeicher, beispielsweise als dynamischer Speicher mit wahlfreiem Zugriff, DRAM (englisch: "dynamic random access memory") oder statischer Speicher mit wahlfreiem Zugriff, SRAM (englisch: "static random access memory"), oder als nicht-flüchtiger Datenspeicher, beispielsweise als Festwertspeicher, ROM (englisch: "read-only memory"), als programmierbarer Festwertspeicher, PROM (englisch: "programmable read-only memory"), als löschbarer programmierbarer Festwertspeicher, EPROM (englisch: "erasable programmable read-only memory"), als elektrisch löschbarer programmierbarer Festwertspeicher, EEPROM (englisch: "electrically erasable programmable read-only memory"), als Flash-Speicher oder Flash-EEPROM, als ferroelektrischer Speicher mit wahlfreiem Zugriff, FRAM (englisch: "ferroelectric random access memory"), als magnetoresistiver Speicher mit wahlfreiem Zugriff, MRAM (englisch: "magnetoresistive random access memory") oder als Phasenänderungsspeicher mit wahlfreiem Zugriff, PCRAM (englisch: "phase-change random access memory"), ausgestaltet sein.

Die Erfindung umfasst auch Weiterbildungen, durch die sich weitere Vorteile ergeben.

Eine Weiterbildung der Erfindung sieht vor, dass die Steuereinheit dazu eingerichtet ist, die MRT-Abbildung nach einem vorgegebenen Registrierungsverfahren in Abhängigkeit von der MRT-Referenzabbildung zu transformieren. Mit anderen Worten ist es vorgesehen, dass die Steuereinheit dazu vorgesehen ist, die MRT-Abbildung mittels einer Anwendung des vorgegebenen Registrierungsverfahrens an die MRT-Referenzabbildung anzugleichen.

Eine Weiterbildung der Erfindung sieht vor, dass das zumindest eine abzugleichende Merkmal eine Ausrichtung der MRT-Abbildung und der MRT-Referenzabbildung umfasst. Mit anderen Worten ist die Steuereinheit dazu eingerichtet, die Ausrichtung der MRT-Abbildung mit der Ausrichtung MRT-Referenzabbildung abzugleichen. Die Steuereinheit ist somit dazu eingerichtet, die MRT-Abbildung derart bereitzustellen, dass diese die gleiche Ausrichtung aufweist, wie die MRT-Referenzabbildung. Die Ausrichtung kann sich beispielsweise auf ein Voxelgitter beziehen. Es kann beispielsweise vorgesehen sein, dass die MRT-Abbildung derart bereitgestellt wird, dass eine Ausrichtung des Voxelgitters in Bezug auf den Abbildungsbereich mit der MRT-Referenzabbildung übereinstimmt. Die Ausrichtung kann beispielsweise durch eine entsprechende Durchführung des MRT-Messvorgangs und/oder des Exportierungsverfahrens bereitgestellt werden. Während des MRT-Messvorgangs kann beispielsweise die Lage der Voxel des Voxelgitters entsprechend eingestellt werden, sodass die Lagen der Voxel der MRT-Abbildung mit den Lagen der Voxel der MRT-Referenzabbildung übereinstimmen oder an diese angenähert sind. Während des Exportierungsverfahrens kann der MRT-Datensatz beispielsweise derart interpoliert werden, dass die MRT-Abbildung ein entsprechend ausgerichtetes Voxelgitter aufweist. Die abzugleichende Ausrichtung kann sich auch auf die MRT-Vorrichtung oder eine Anatomie des Objektes beziehen.

Eine Weiterbildung der Erfindung sieht vor, dass das zumindest eine abzugleichende Merkmal eine Ortsauflösung der MRT-Abbildung und der MRT-Referenzabbildung umfasst. Mit anderen Worten ist die Steuereinheit dazu eingerichtet, die Ortsauflösung der MRT-Abbildung mit der Ortsauflösung der MRT-Referenzabbildung abzugleichen. Die Steuereinheit ist somit dazu eingerichtet, die MRT-Abbildung derart bereitzustellen, dass diese die gleiche Ortsauflösung aufweist, wie die MRT-Referenzabbildung. Die Einstellung der Ortsauflösung kann beispielsweise durch eine Einstellung der Auflösung der Erfassung der MRT-Daten in dem MRT-Messvorgang erfolgen. Zusätzlich oder alternativ dazu kann der MRT-Datensatz entsprechend interpoliert oder reduziert werden, um die MRT-Aufnahme mit der Ortsauflösung bereitzustellen.

Eine Weiterbildung der Erfindung sieht vor, dass das zumindest eine abzugleichende Merkmal eine Abdeckung der MRT-Abbildung und der MRT-Referenzabbildung umfasst. Mit anderen Worten ist die Steuereinheit dazu eingerichtet, die Abdeckung der MRT-Abbildung mit der Abdeckung der MRT-Referenzabbildung abzugleichen. Die Abdeckung kann beispielsweise ein in der MRT-Abbildung abgebildetes Volumen oder eine in der MRT-Abbildung abgebildete Fläche betreffen. Die Abdeckung kann auch in der MRT-Abbildung abgebildete Subobjekte des Objektes, wie beispielsweise Organe betreffen. Es kann beispielsweise vorgesehen sein, dass die Steuereinheit dazu eingerichtet ist, die MRT-Vorrichtung derart anzusteuern, dass sichergestellt ist, dass ein in der MRT-Referenzabbildung identifiziertes vorgegebenes Organ vollständig durch die MRT-Vorrichtung in der MRT-Messung erfasst wird. Die MRT-Abbildung kann das Organ folglich vollständig abbilden, Somit kann sichergestellt sein, dass die MRT-Abbildung eine erforderliche Abdeckung des Organs aufweist. Eine gleiche Abdeckung kann auch ein Beschneiden des MRT-Datensatzes während des Exportierungsverfahrens umfassen, sodass eine Abdeckung der MRT-Abbildung nicht größer ist als eine Abdeckung der MRT-Referenzabbildung.

Eine Weiterbildung der Erfindung sieht vor, dass das zumindest eine abzugleichende Merkmal eine Position zumindest einer Referenz in der MRT-Abbildung und der MRT-Referenzabbildung umfasst. Mit anderen Worten ist die Steuereinheit dazu eingerichtet, die MRT-Abbildung derart auszugeben, dass zumindest eine Referenz in der MRT-Abbildung eine identische Position in der MRT-Abbildung aufweist, wie in der MRT-Referenzabbildung. Es kann auch vorgesehen sein, dass mehrere Referenzen jeweils identische Positionen aufweisen müssen. Mit einer Position in Bezug auf die MRT-Abbildung kann beispielsweise eine Pixelkoordinate bezeichnet sein.

Eine Weiterbildung der Erfindung sieht vor, dass die Steuereinheit dazu eingerichtet ist, nach einem vorbestimmten Qualitätsermittlungsverfahren zumindest ein vorgegebenes Qualitätsmerkmal der MRT-Abbildung zu ermitteln. Mit anderen Worten ist die Steuereinheit dazu eingerichtet, eine Qualität der MRT-Abbildung zu ermitteln. Die Qualität kann dabei in dem zumindest einen Qualitätsmerkmal beschrieben sein, welches nach dem Qualitätsermittlungsverfahren bestimmt wird. Das zumindest eine Qualitätsmerkmal kann beispielsweise ein Signal-zu-Rausch-Verhältnis, einen Bildkontrast, einen Dynamikumfang, oder eine Bildschärfe umfassen. Das Qualitätsermittlungsverfahren kann ein Bildverarbeitungsverfahren, eine KI-basierte Auswertungen oder vorgegebene Algorithmen umfassen. Das Qualitätsmerkmal kann von der Qualität der MRT-Abbildung im Sinne einer Bildqualität abhängen oder von dem durch die MRT-Abbildung abgebildeten Inhalt. Letzterer kann Beispielsweise unter Einbeziehung einer semantischen Segmentierung und Objekterkennungsverfahren bewertet werden.

Eine Weiterbildung der Erfindung sieht vor, dass die Steuereinheit dazu eingerichtet ist, die MRT-Abbildung nach dem vorgegebenen Registrierungsverfahren nur zu transformieren, wenn durch das zumindest eine Qualitätsmerkmal der MRT-Abbildung ein vorgegebenes Qualitätskriterium erfüllt ist. Es kann beispielsweise vorgesehen sein, dass das Qualitätskriterium vorgibt, dass ein Signal-zu-Rausch-Verhältnis der MRT-Abbildung nicht überschritten wird. Dadurch kann sichergestellt sein, dass nur MRT-Aufnahmen mit einer ausreichenden Bildqualität verarbeitet werden.

Eine Weiterbildung der Erfindung sieht vor, dass die Steuereinheit dazu eingerichtet ist, in einem vorgegebenen Korrekturverfahren in Abhängigkeit von dem zumindest einen Qualitätsmerkmal zumindest eine Korrekturvorgabe zur Verbesserung des Qualitätsmerkmals zu ermitteln. Es kann beispielsweise vorgesehen sein, dass in der Steuereinheit eine Datenbank aufweist, in welcher Korrekturvorgaben gespeichert sind, welche Anweisungen an die MRT-Vorrichtung und/oder menschlich lesbare Anweisungen umfasst, welche abgerufen werden, falls ein Qualitätsmerkmal das Qualitätskriterium nicht erfüllt. Es kann beispielsweise vorgesehen sein, dass die Korrekturvorgabe eine Anweisung zur Änderung einer Lage des Objektes umfasst, oder einen Steuerbefehl zur Reduzierung einer Erfassungszeit der MRT-Messung, falls es zu Bewegungsartefakten kam.

Ein zweiter Aspekt der Erfindung betrifft ein Verfahren zum Betreiben einer Steuereinheit.

Durch die Steuereinheit wird eine Bereitstellungsanfrage zur Bereitstellung einer MRT-Abbildung des geometrischen Abbildungsbereiches des Objektes empfangen, wobei die Bereitstellungsanfrage eine Vorgabe betreffend zumindest ein zwischen der MRT-Referenzabbildung und der MRT-Abbildung abzugleichendes Merkmal umfasst. Die MRT-Referenzabbildung bildet den geometrischen Abbildungsbereich des Objektes ab.

Durch die Steuereinheit wird nach einem Messverfahren eine MRT-Vorrichtung gemäß der zumindest einen Vorgabe zur Durchführung einer vorgegebenen MRT-Messung zumindest an dem geometrischen Abbildungsbereich des Objekts angesteuert, und ein in der Messung generierter MRT-Datensatz empfangen.

Durch die Steuereinheit wird nach einem vorgegebenen Exportierungsverfahren aus dem MRT-Datensatz die MRT-Abbildung des geometrischen Abbildungsbereiches des Objektes gemäß der zumindest einen Vorgabe generiert.

Für Anwendungsfälle oder Anwendungssituationen, die sich bei dem Verfahren ergeben können und die hier nicht explizit beschrieben sind, kann vorgesehen sein, dass gemäß dem Verfahren eine Fehlermeldung und/oder eine Aufforderung zur Eingabe einer Nutzerrückmeldung ausgegeben und/oder eine Standardeinstellung und/oder ein vorbestimmter Initialzustand eingestellt wird.

Ein dritter Aspekt der Erfindung betrifft eine MRT-Vorrichtung, welche zumindest eine Steuereinheit gemäß dem ersten Aspekt der Erfindung umfasst.

Gemäß einem vierten Aspekt umfasst die Erfindung auch ein Computerprogramm umfassend Befehle, die bei der Ausführung des Programms durch eine Steuereinheit, diese veranlassen, das Verfahren gemäß dem zweiten Aspekt auszuführen.

Gemäß einem fünften Aspekt der Erfindung wird ein computerlesbares Speichermedium angegeben, welches ein Computerprogramm gemäß dem vierten Aspekt der Erfindung speichert.

Das Computerprogramm und das computerlesbare Speichermedium können als entsprechende Computerprogrammprodukte mit den Befehlen aufgefasst werden.

Weitere Merkmale der Erfindung ergeben sich aus den Ansprüchen, den Figuren und der Figurenbeschreibung. Die vorstehend in der Beschreibung genannten Merkmale und Merkmalskombinationen sowie die nachfolgend in der Figurenbeschreibung genannten und/oder in den Figuren gezeigten Merkmale und Merkmalskombinationen können nicht nur in der jeweils angegebenen Kombination, sondern auch in anderen Kombinationen von der Erfindung umfasst sein. Es können insbesondere auch Ausführungen und Merkmalskombinationen von der Erfindung umfasst sein, die nicht alle Merkmale eines ursprünglich formulierten Anspruchs aufweisen. Es können darüber hinaus Ausführungen und Merkmalskombinationen von der Erfindung umfasst, die über die in den Rückbezügen der Ansprüche dargelegten Merkmalskombinationen hinausgehen oder von diesen abweichen.

Die Erfindung wird im Folgenden anhand konkreter Ausführungsbeispiele und zugehöriger schematischer Zeichnungen näher erläutert. In den Figuren können gleiche oder funktionsgleiche Elemente mit denselben Bezugszeichen versehen sein. Die Beschreibung gleicher oder funktionsgleicher Elemente wird gegebenenfalls nicht notwendigerweise bezüglich verschiedener Figuren wiederholt.

In den Figuren zeigen:
- FIG 1: eine schematische Darstellung einer MRT-Vorrichtung, welche eine Steuereinheit aufweist;
- FIG 2: eine schematische Darstellung eines Verfahrens zum Betreiben einer Steuereinheit;
- FIG 3: eine schematische Darstellung potentieller Verfahrensschritte eines Verfahrens zum Betreiben einer Steuereinheit; und
- FIG 4: eine schematische Darstellung einer Benutzerschnittstelle einer Steuereinheit.

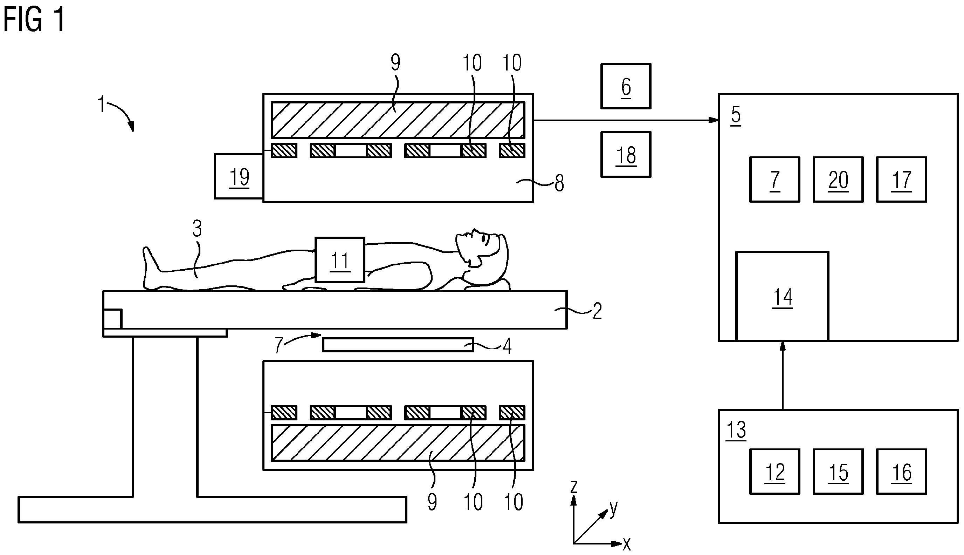

In FIG 1 ist eine schematische Darstellung einer MRT-Vorrichtung zur Magnetresonanztomographie dargestellt.

Die MRT-Vorrichtung 1 weist eine Objektauflage 2 auf, die beispielsweise als Patientenliege oder Patiententisch ausgestaltet ist. Auf der Objektauflage 2 kann ein zu untersuchendes Objekt 3, beispielsweise ein Patient, angeordnet werden. Außerdem weist die Vorrichtung 1 eine Magneteinheit 8 auf, die einen Feldmagneten 9 zur Erzeugung eines möglichst homogenen Grundmagnetfelds sowie eine oder mehrere Gradientenspulen 10 zur Erzeugung von räumlich veränderlichen Magnetfeldgradienten zur räumlichen Codierung entsprechender MR-Signale aufweist.

Der Feldmagnet 9 kann ein statisches Magnetfeld zur Ausrichtung der Kernspins des Objekts 3 in einem entsprechenden Aufnahmebereich erzeugen. Der Aufnahmebereich zeichnet sich durch ein äußerst homogenes statisches Magnetfeld aus, wobei die Homogenität insbesondere die Magnetfeldstärke beziehungsweise deren Betrag betrifft. Der Feldmagnet 9 kann beispielsweise einen supraleitenden Magneten aufweisen, der magnetische Felder mit einer magnetischen Flussdichte von bis zu 3 T, bei neueren Geräten auch darüber, bereitstellen kann. Für geringere Feldstärken können jedoch auch Permanentmagnete oder Elektromagnete mit normalleitenden Spulen Verwendung finden.

Die Gradientenspulen 10 sind dazu ausgelegt, zur räumlichen Differenzierung der erfassten Abbildungsbereiche 11 in dem Untersuchungsvolumen dem Grundmagnetfeld, also dem statischen durch den Feldmagneten 9 erzeugten Magnetfeld, variable Magnetfelder in alle drei Raumrichtungen zu überlagern, um so den Gradienten zu realisieren. Üblicherweise können die Gradientenspulen 10 normalleitende Spulen beinhalten, die zueinander orthogonale Felder erzeugen können.

Die MRT-Vorrichtung 1 weist außerdem eine Empfangsspuleneinheit 4 auf, die eine Empfangsspule beinhaltet, sowie beispielsweise ein Gehäuse. Die Empfangsspule kann dabei auch als Sendespule fungieren oder die MRT-Vorrichtung 1 kann eine separate Sendespule aufweisen. Über eine Signalleitung kann der Sendespule ein Hochfrequenzsignal zugeführt werden, um entsprechende Signalpulse auszusenden, insbesondere in das Objekt 3 auszusenden. Die Empfangsspule ist dazu eingerichtet, aus dem Objekt 3 emittierte MR-Signale, auch als Resonanzsignale bezeichnet, zu empfangen.

Eine Steuereinheit 5 der MRT-Vorrichtung 1 versorgt die Magneteinheit 8 mit entsprechenden Signalen und wertet die empfangenen MR-Signale der Empfangsspule aus. Die Steuereinheit 5 kann dazu eingerichtet sein, einen MRT-Datensatz 6, welcher während einer MRT-Messung durch die MRT-Vorrichtung 1 erfasst wurde zu empfangen, um eine MRT-Abbildung 7 aus dem MRT-Datensatz 6 zu generieren. Es kann vorgesehen sein, dass die MRT-Abbildung 7 mit zumindest einer weiteren MRT-Abbildung 7 durch die Steuereinheit 5 nach einem Registrierungsverfahren zu registrieren ist. Zu diesem Zweck kann es vorteilhaft oder erforderlich sein, die MRT-Abbildung 7 derart auszugeben, dass sie mit der weiteren MRT-Abbildung 7 eine gleiche Ausrichtung aufweist. Als Referenz kann der Steuereinheit 5 eine MRT-Referenzabbildung 20 vorliegen, welche eine vorab erfasste MRT-Abbildung 7 eines Abbildungsbereiches 11 des Objekts 3 abbilden kann. Die Steuereinheit 5 kann dazu eingerichtet sein, die MRT-Vorrichtung 1 derart anzusteuern, dass der MRT-Datensatz 6 eine Erzeugung einer MRT-Abbildung 7 ermöglicht, welche einen gleichen Abbildungsbereich 11 abbildet, wie die MRT-Referenzabbildung 20.

Die Steuereinheit 5 kann dazu eingerichtet sein, eine Lage des Abbildungsbereichs 11 in einem Prescan des Objekts 3 zu identifizieren und die MRT-Vorrichtung 1 zur Erfassung des Abbildungsbereiches 11 anzusteuern. Dabei kann beispielsweise eine Lage einer Erfassungsebene entsprechend in der MRT-Vorrichtung 1 vorgegeben werden.

Um eine qualitativ hochwertige Registrierung der MRT-Abbildungen 7 zu ermöglichen, kann die MRT-Vorrichtung 1 derart angesteuert werden, dass bestimmte Merkmale 12 in der MRT-Referenzabbildung 20 und der MRT-Abbildung 7 übereinstimmen. Die Merkmale 12 können beispielsweise eine Ortsauflösung, eine Abdeckung oder eine Ausrichtung umfassen. Die Merkmale 12 können in einer Bereitstellungsanfrage 13 festgelegt sein, welche durch die Steuereinheit 5 empfangen sein kann. Die Steuereinheit 5 kann hierfür beispielsweise eine Schnittstelle 14zum Empfangen von Signalen und/oder eine Benutzereingabestelle zum Erfassen vorgegebener Benutzereingaben umfassen. Die Bereitstellungsanfrage 13 kann auch Qualitätsmerkmale 15 vorgeben, welche durch die Steuereinheit 5 ermittelt werden sollen und die MRT-Abbildung 7 betreffen. Des Weiteren kann die Bereitstellungsanfrage 13 ein Qualitätskriterium 16 vorgeben, dass zur Registrierung der MRT-Abbildung 7 durch das Qualitätsmerkmal 15 erfüllt sein muss. Die Bereitstellungsanfrage 13 kann vorgeben, dass die Steuereinheit 5 für eine Verbesserung der Qualität in einem vorgegebenen Korrekturverfahren in Abhängigkeit von dem zumindest einen Qualitätsmerkmal zumindest eine Korrekturvorgabe zur Verbesserung des Qualitätsmerkmals ermittelt und bereitstellt.

Der Qualitätsmerkmal kann auch in Abhängigkeit zumindest eines Sensorwertes 18 ermittelt werden, der durch eine Sensoreinheit 19 der MRT-Vorrichtung 1 ermittelt worden sein kann. Der Sensorwert 18 kann beispielsweise eine durch die Sensoreinheit 19 ermittelte Lage des Objektes 3 oder eine ermittelte Bewegung des Objektes 3 in der MRT-Vorrichtung 1 während der MRT-Messung umfassen.

Die Steuereinheit 5 kann den MRT-Datensatz 6 gemäß der Vorgaben nach einem Exportierungsverfahren auswerten, um die MRT-Abbildung 7 auszugeben. Die MRT-Abbildung 7 kann nach einem vorgegebenen Registrierungsverfahren transformiert werden, um die MRT-Abbildung 7 mit der MRT-Referenzabbildung 20 abzugleichen. Dadurch kann ein Sammlung 17 registrierter MRT-Abbildungen 7 bereitgestellt werden.

Die Empfangsspuleneinheit 4 beziehungsweise die Empfangsspule ist nicht in die Objektauflage 2 integriert, ist aber auch nicht starr und unbeweglich mit der Magneteinheit 8 verbunden. Stattdessen ist die Empfangsspule in einer Vertikalrichtung z unterhalb der Objektauflage 2 angeordnet und entlang der Vertikalrichtung z verschiebbar gelagert, sodass ein Abstand 11 zwischen Empfangsspule und Objektauflage 2 veränderbar ist.

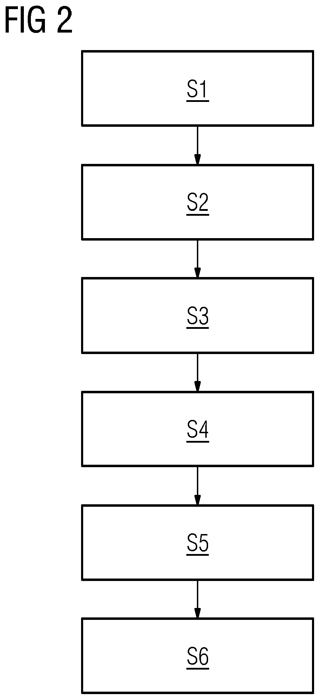

FIG 2 zeigt eine schematische Darstellung eines Verfahrens zum Betreiben einer Steuereinheit;

Gezeigt ist ein Verfahrensablauf, welcher als vollautomatischer Arbeitsablauf nach benutzerdefinierten Untersuchungsstrategien erfolgen kann. Das Verfahren kann durch eine Steuereinheit 5 ausgeführt werden.

Das Verfahren kann es ermöglichen, MRT-Abbildungen 7 aus MRT-Untersuchungen nach verschiedenen MRT-Protokollen abzugleichen.

In einem ersten Schritt S1 kann die Steuereinheit 5 eine Bereitstellungsanfrage 13 zur Bereitstellung zumindest einer MRT-Abbildung 7 eines geometrischen Abbildungsbereiches 11 eines Objektes 3 empfangen. Die Bereitstellungsanfrage 13 kann eine Vorgabe eines MRT-Referenzdatensatz umfassen, wobei der MRT-Referenzdatensatz eine MRT-Referenzabbildung 20 umfasst, welche den geometrischen Abbildungsbereich 11 des Objektes 3 abbildet. Die MRT-Referenzabbildung 20 kann eine Referenz sein, mit welcher die zumindest eine bereitzustellende MRT-Abbildung 7 abzugleichen ist. Es können durch die Bereitstellungsanfrage 13 auch mehrere der MRT-Abbildungen 7 angefragt werden, welche nach jeweiligen MRT-Protokollen erfasst werden.

Mit anderen Worten ist es in dem Verfahren vorgesehen, dass die zumindest eine MRT-Abbildung 7 des jeweiligen ausgewählten MRT-Protokolls automatisch ausgerichtet wird. Als Referenz für die Ausrichtung kann die MRT-Referenzaufnahme, beispielsweise eine frühere MRT-Abbildung 7 des Patienten, der untersucht werden soll, oder ein stereotaktischer Standardraum wie der MNI152/ICBM2009C dienen. Letzteres kann insbesondere für Gehirnstudien vorgesehen sein.

Die Bereitstellungsanfrage 13 kann eine Vorgabe, betreffend zumindest ein zwischen der MRT-Referenzabbildung 20 und der zumindest einen MRT-Abbildung 7 abzugleichendes Merkmal 12 umfassen. Das zumindest eine abzugleichende Merkmal 12 kann dabei für die einzelnen MRT-Abbildungen 7einzeln ausgewählt werden, falls mehrere der MRT-Abbildungen 7angefragt werden.

Das zumindest eine abzugleichende Merkmal 12 kann eine Bildausrichtung der MRT-Aufnahme, eine Position der MRT-Aufnahme, eine darzustellende Abdeckung einer Anatomie in der MRT-Abbildung 7 oder eine Auflösung der MRT-Abbildung 7 umfassen. Das zumindest eine abzugleichende Merkmal 12 kann an klinischen Anforderungen und eine mögliche anschließende Gruppenanalyse angepasst sein.

Der Abgleich kann durch die Steuereinheit 5 in folgenden Schritten gemäß den vorgegebenen Merkmalen 12 erfolgen.

Der Abgleich kann beispielsweise in einem Schritt S2 durch eine entsprechende Ansteuerung der MRT-Vorrichtung 1 durch die Steuereinheit 5 in einem Messverfahren erfolgen. Es kann beispielsweise vorgesehen sein, eine Erfassung eines Datensatzes zur Erzeugung einer bereitzustellenden 3D-MRT-Abbildung 7 in Abhängigkeit von einer Ausrichtung einer 2D-MRT-Referenzaufnahme derart durchzuführen, dass eine Hauptorientierung der bereitzustellenden 3D-MRT-Abbildung 7 an eine 2D-Orientierung der 2D-MRT-Referenzaufnahme angepasst ist. Dies ergibt den Vorteil, dass Interpolationsartefakte bei der Generierung der 3D-MRT-Abbildung 7 in dem Exportierungsverfahren reduziert werden können.

In einem Schritt S3 kann das Exportierungsverfahren durch die Steuereinheit 5 durchgeführt werden, um aus dem MRT-Datensatz 6 gemäß den Vorgaben die MRT-Abbildung 7 zu erzeugen. Das Exportierungsverfahren kann eine Auflösungsanpassung umfassen, um die MRT-Abbildung 7 mit einer von einer Auflösung des Datensatzes abweichenden Auflösung zu generieren.

In einem Schritt S4 kann die Bildqualität anhand verschiedener Qualitätsmerkmalen durch die Steuereinheit 5 nach einem vorgegebenen Qualitätsermittlungsverfahren automatisch bewertet werden, um die Robustheit der Registrierung sicherzustellen. Die Qualitätsmerkmale 15 können ein Signal-zu-Rausch Verhältnis, anwesende Artefakte und/oder anwesende Bewegungsartefakte betreffen. Bei Bedarf könnte die Art der Artefakte klassifiziert werden. Die Bewertung der zumindest einen MRT-Abbildung 7 nach dem vorgegebenen Qualitätsermittlungsverfahren kann nach Abschluss der gesamten Studie oder nach jeder einzelnen Bereitstellung der jeweiligen MRT-Abbildung 7 erfolgen. Im letzteren Fall können die Ergebnisse dem Benutzer sofort zur Verfügung gestellt, und der Benutzer kann entscheiden, ob die Studie gestoppt werden kann und weitere Maßnahmen erforderlich sind.

Das Qualitätsermittlungsverfahren könnte eine Bewertung der jeweiligen MRT-Abbildungen 7mittels eines Qualitätsmerkmals ausgeben, die angibt, wie vertrauenswürdig die MRT-Abbildungen 7sind. Dies kann in einer dreistufigen Skala angegeben sein: gut, akzeptabel und schlecht. Zusätzlich könnten Sensorwerte 18 wie Bewegungsmeldungen, Pilot-Tone-Signale oder Physio-Signale aus Sensoreinheiten 19 in diese Bewertung einfließen. Darüber hinaus könnten für eine stabilere und genauere Bewertung der Bildqualität auch trainierte maschinelle Lernmodelle auf der Grundlage großer Datenmengen verwendet werden. Das Ergebnis der Analyse könnte auch eine Klassifizierung der Bildartefakte umfassen. Das Ergebnis könnte beispielsweise angeben, dass ein Bewegungsartefakt aufgetreten ist, zusammen mit einer Wahrscheinlichkeit einer jeweiligen Klassifizierung, wenn die Artefaktklassifizierung in der Bereitstellungsanfrage 13 vorgegeben ist.

In einem Schritt S4 könnte auch eine Korrekturvorgabe durch die Steuereinheit 5 ermittelt und ausgegeben werden. Die Steuereinheit 5 könnte nach einem vorgegebenen Korrekturverfahren in Abhängigkeit von dem zumindest einen Qualitätsmerkmal 15 zumindest eine Korrekturvorgabe zur Verbesserung des Qualitätsmerkmals 15 ermitteln. Die Korrekturvorgabe kann beschreiben, wie eine folgende MRT-Messung angepasst werden kann, um den zumindest einen Qualitätsmerkmal in zukünftigen MRT-Abbildungen 7gegenüber vorhergehender MRT-Abbildungen 7verbessern zu können. Die Korrekturvorgabe kann beispielsweise bei einer Erfassung eines Artefakts in der MRT-Abbildung 7 Änderungen bei der Durchführung der MRT-Messung vorschlagen, um ein Auftreten des Artefakts in den zukünftigen MRT-Abbildungen 7zu vermeiden.

Mögliche in MRT-Abbildungen 7 auszumachende Artefakte können Bewegungsartefakte, Spulenprobleme, eine falsche Positionierung des Objekts 3, ein falsches Sichtfeld, Strömungsartefakte, physiologische Unregelmäßigkeiten aufgrund einer Atmung oder eines Herzzyklus, anatomische Abweichungen, Implantate, oder Metallartefakte umfassen. Eine solche Korrekturvorgabe kann auf der Grundlage einer Teilmenge der MRT-Abbildungen 7 der MRT-Protokolle gegeben werden, sobald diese verfügbar ist. Dies bedeutet, dass die Korrekturvorgabe nicht erst erfolgt, nachdem alle MRT-Abbildungen 7 der jeweiligen MRT-Protokolle erfasst wurden.

In einem Schritt S5 können alle MRT-Abbildungen 7 anhand der jeweiligen Qualitätsmerkmale 15 darauf überprüft werden, ob diese ein vorgegebenes Qualitätskriterium 16 erfüllen.
Mit anderen Worten werden vor der Durchführung des Registrierungsverfahrens alle MRT-Abbildungen 7 automatisch durch die Steuereinheit 5 auf eine Einhaltung des Qualitätskriteriums 16 überprüft, um anschließend eine qualitativ hochwertige Registrierung der MRT-Abbildungen 7 zu ermöglichen. Die Einhaltung des Qualitätskriteriums 16, sowie das Qualitätskriterium 16 können in der Bereitstellungsanfrage 13 festgelegt sein.

In einem Schritt S6 können alle MRT-Abbildungen 7 oder zumindest die MRT-Abbildungen 7, welche das Qualitätskriterium 16 erfüllen, nach einem vorgegebenen Registrierungsverfahren in Abhängigkeit von der MRT-Referenzabbildung 20 transformiert werden.

Die in dem Verfahren ausgerichteten MRT-Abbildungen 7 aus diesen MRT-Protokollen könnten dann leichter verglichen und auf die Erkennung von Läsionen, anatomischen Veränderungen oder Unstimmigkeiten überprüft werden. Solche MRT-Abbildungen 7 könnten hervorgehoben werden. Außerdem könnten die abgeglichenen MRT-Abbildungen 7 leichter für den Abgleich mit Aufnahmen aus anderen Bildgebungsverfahren wie der Positronen-Emissions-Tomographie oder der Computertomographie verwendet werden. Die Verwendung der MRT-Abbildungen 7 in der Therapieplanung könnte dadurch leichter möglich sein. Um dies zu ermöglichen kann es vorgesehen sein, dass es sich bei der Referenzabbildung 20 auch um eine Abbildung handeln kann, welche nach einem anderen Bildgebungsverfahren als der Magnetresonanztomographie erzeugt sein kann. Es kann beispielsweise vorgesehen sein, dass die Referenzabbildung 20 mittels Positronen-Emissions-Tomographie oder der Computertomographie erzeugt worden sein kann.

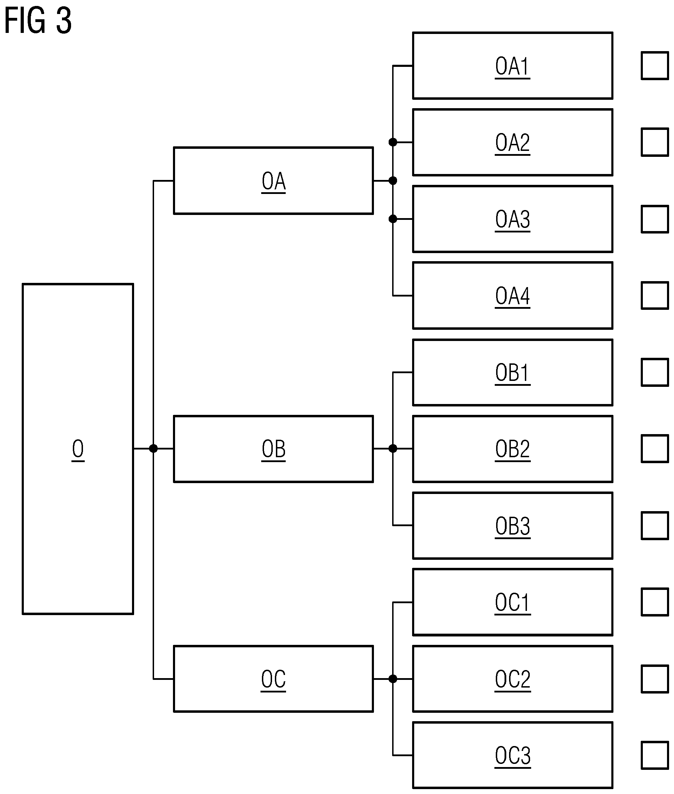

FIG 3 zeigt eine schematische Darstellung potentieller Verfahrensschritte eines Verfahrens zum Betreiben einer Steuereinheit.

Nachfolgend eine einfache Skizze von Optionen, die durch die Steuereinheit 5 zur Anwendung in einem Verfahren bereitgestellt werden können. Die in dem Verfahren zu berücksichtigenden Optionen können durch einen Benutzer in der Bereitstellungsanfrage 13 ausgewählt werden. Die Optionen können durch den Benutzer vor einer Einleitung einer ersten MRT-Untersuchung auf der Grundlage der Bedürfnisse des Technologen oder Radiologen festgelegt werden.

Die Steuereinheit 5 kann eine Schnittstelle 14 aufweisen, welche eine zentrale Benutzeroberfläche aufweisen kann. Die Benutzeroberfläche kann eine Auswahl der jeweiligen Optionen O für die bereitzustellenden MRT-Abbildungen 7 aus den jeweiligen MRT-Protokollen ermöglichen.

Die Optionen O können nach Gruppen gegliedert sein.

Eine ausrichtungsbezogene Gruppe OA kann Vorgaben in Bezug auf die Ausrichtung der jeweiligen MRT-Abbildung 7 in Bezug auf die MRT-Referenzaufnahme umfassen. Die Vorgaben können beispielsweise einen Abgleich einer Orientierung "Orientation Match" (OA1), einen Abgleich einer Lage "Position Match" (OA2), einen Abgleich einer Abdeckung "Anatomic Match" (OA3), und einen Abgleich einer örtlichen Auflösung "Resolution Match" (OA4)umfassen.

Eine qualitätsbezogene Gruppe OB kann eine Durchführung einer Bewertung der MRT-Abbildung 7 "Rating" (OB1)als Option umfassen. Dabei kann zumindest ein Qualitätsmerkmal eingestellt werden. Die Qualitätsbezogene Gruppe OB kann eine Artefaktklassifizierung (OB2) zur Ermittlung einer Art eines in der MRT-Abbildung 7 identifizierten Artefaktes als Option umfassen, sowie eine Ermittlung einer "Scan Interaction" (OB3) .

Eine korrekturbezogene Gruppe OC kann Optionen umfassen, die sich auf eine Ermittlung und Ausgabe der Korrekturvorgaben zur Verbesserung des Qualitätsmerkmals der MRT-Abbildung 7 beziehen. Diese Optionen können eine Ermittlung von Korrekturvorgaben bezüglich einer Position (OC1) des Objektes 3, bezüglich einer Anleitung eines Patienten (OC2), oder bezüglich einer Einstellung der MRT-Vorrichtung 1 (OC3) umfassen.

Die Ausrichtung könnte prospektiv durch automatische Anpassung der MRT-Protokollausrichtung oder retrospektiv durch Registrierung und/oder Interpolation zur Anpassung der Auflösung erfolgen.

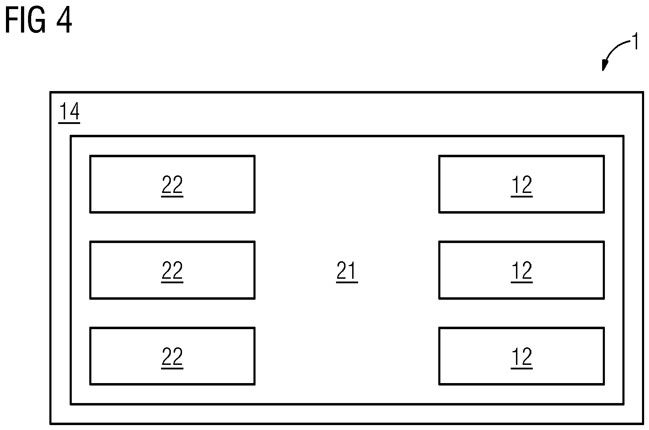

FIG 4 zeigt eine schematische Darstellung einer Benutzerschnittstelle einer Steuereinheit.

Die Benutzerschnittstelle 14 der MRT-Vorrichtung 1 zeigt eine Liste von MRT-Protokollen, wobei den jeweiligen MRT-Messprotokollen 22 einer MRT-Messreihe 21 die abzustimmenden Merkmale 12 zugewiesen sein können.

Ein gemeinsamer Abgleich von Bildern aus verschiedenen MRT-Protokollen 2D und 3D einer bestimmten Studie sollte eine bessere Konsistenzprüfung, eine schnellere Diagnose und die folgenden Gruppenanalysen ermöglichen.

Eine gut ausgerichtete Studie könnte leichter mit anderen Modalitäten CT oder PET im Schritt der Bildfusion oder für die Therapieplanung abgeglichen werden.

Ein Online-Verfahren zur Überprüfung der Bildqualität könnte anschließend eine qualitativ hochwertige Bildregistrierung ermöglichen und einen nützlichen Interaktionsmodus bieten, bei dem die Benutzer entscheiden können, ob der Scan gestoppt werden soll und ob zwischendurch weitere Maßnahmen erforderlich sind.

Es könnte eine Empfehlung zur Vermeidung von Artefakten in einem nachfolgenden Scan gegeben werden, z.B. könnte die Art der Artefakte klassifiziert werden, z.B. in Bewegungsartefakte, Spulenprobleme, falsche Positionierung, falsches FOV, Flussartefakte, physiologische Unregelmäßigkeiten Atmung, Herzzyklus, anatomische Herausforderungen, Implantate, Metallartefakte Tätowierungen, Make-up, Metallteile in der Kleidung.

## Patentansprüche

1. Steuereinheit (5),
**dadurch gekennzeichnet, dass**
die Steuereinheit (5) dazu eingerichtet ist,
- eine Bereitstellungsanfrage (13) zur Bereitstellung einer MRT-Abbildung (7) eines geometrischen Abbildungsbereiches (11) eines Objektes (3) zu empfangen, wobei die Bereitstellungsanfrage (13) eine Vorgabe, betreffend zumindest ein zwischen einer MRT-Referenzabbildung (20) des Abbildungsbereichs (11) und der MRT-Abbildung (7) abzugleichendes Merkmal (12) umfasst,
- nach einem vorgegebenen Messverfahren eine MRT-Vorrichtung (1) gemäß der Vorgabe zur Durchführung einer vorgegebenen MRT-Messung zumindest an dem geometrischen Abbildungsbereich (11) des Objekt (3) anzusteuern, und einen in der Messung generierten MRT-Datensatz (6) zu empfangen, und
- nach einem vorgegebenen Exportierungsverfahren aus dem MRT-Datensatz (6) die MRT-Abbildung (7) des geometrischen Abbildungsbereiches (11) des Objektes (3) gemäß der zumindest einen Vorgabe bereitzustellen.

2. Steuereinheit (5) nach Anspruch 1, wobei die Steuereinheit (5) dazu eingerichtet ist, die MRT-Abbildung (7) nach einem vorgegebenen Registrierungsverfahren in Abhängigkeit von der MRT-Referenzabbildung (20) zu transformieren.

3. Steuereinheit (5) nach Anspruch 1 oder 2, wobei das zumindest eine abzugleichende Merkmal (12) eine abzugleichende Ausrichtung der MRT-Abbildung (7) mit der Ausrichtung der MRT-Abbildung (7) in Bezug auf ein vorgegebenes Referenzsystem umfasst.

4. Steuereinheit (5) nach einem der vorhergehenden Ansprüche, wobei das zumindest eine abzugleichende Merkmal (12) eine abzugleichende Ortsauflösung der MRT-Abbildung (7) mit der Ortsauflösung der MRT-Referenzabbildung (20) umfasst.

5. Steuereinheit (5) nach einem der vorhergehenden Ansprüche, wobei das zumindest eine abzugleichende Merkmal (12) eine abzugleichende Abdeckung der MRT-Abbildung (7) mit der Abdeckung der MRT-Referenzabbildung (20) umfasst.

6. Steuereinheit (5) nach einem der vorhergehenden Ansprüche, wobei das zumindest eine abzugleichende Merkmal (12) eine abzugleichende Position zumindest einer vorgegebenen Referenz in der MRT-Abbildung (7) mit der Position der zumindest einen vorgegebenen Referenz in der MRT-Referenzabbildung (20) umfasst.

7. Steuereinheit (5) nach einem der vorhergehenden Ansprüche, wobei die Steuereinheit (5) dazu eingerichtet ist, nach einem vorbestimmten Qualitätsermittlungsverfahren zumindest ein vorgegebenes Qualitätsmerkmal (15) der MRT-Abbildung (7) zu ermitteln.

8. Steuereinheit (5) nach Anspruch 7, wobei die Steuereinheit (5) dazu eingerichtet ist, die MRT-Abbildung (7) nach dem vorgegebenen Registrierungsverfahren nur zu transformieren, wenn durch das zumindest eine Qualitätsmerkmal (15) der MRT-Abbildung (7) ein vorgegebenes Qualitätskriterium (16) erfüllt ist.

9. Steuereinheit (5) nach Anspruch 7 oder 8, wobei die Steuereinheit (5) dazu eingerichtet ist, in einem vorgegebenen Korrekturverfahren in Abhängigkeit von dem zumindest einen Qualitätsmerkmal (15) zumindest eine Korrekturvorgabe zur Verbesserung des Qualitätsmerkmals (15) zu ermitteln.

10. Verfahren zum Betreiben einer Steuereinheit (5),
**dadurch gekennzeichnet, dass**
durch die Steuereinheit (5),
- eine Bereitstellungsanfrage (13) zur Bereitstellung einer MRT-Abbildung (7) eines geometrischen Abbildungsbereiches (11) eines Objektes (3) empfangen wird, wobei die Bereitstellungsanfrage (13) eine Vorgabe betreffend zumindest ein zwischen einer MRT-Referenzabbildung (20) und der MRT-Abbildung (7) abzugleichendes Merkmal (12) umfasst, wobei die MRT-Referenzabbildung (20) einen geometrischen Abbildungsbereich (11) des Objektes (3) abbildet,
- nach einem Messverfahren eine MRT-Vorrichtung (1) gemäß der Vorgabe zur Durchführung einer vorgegebenen MRT-Messung zumindest an dem geometrischen Abbildungsbereich (11) des Objekt (3) angesteuert wird, und ein in der Messung generierter MRT-Datensatz (6) empfangen wird,
- nach einem vorgegebenen Exportierungsverfahren aus dem MRT-Datensatz (6) die MRT-Abbildung (7) des geometrischen Abbildungsbereiches (11) des Objektes (3) gemäß der zumindest einen Vorgabe bereitgestellt wird.

11. MRT-Vorrichtung (1), umfassend zumindest eine Steuereinheit (5) nach einem der Ansprüche 1 bis 9.

12. Computerprogramm, welches direkt in einen Speicher einer Steuereinheit (5) nach einem der Ansprüche 1 bis 9 ladbar ist, mit Programm-Mitteln, um die Schritte des Verfahrens nach Anspruch 10 auszuführen, wenn das Programm in der Steuereinheit (5) ausgeführt wird.

13. Elektronisch lesbarer Datenträger mit darauf gespeicherten elektronisch lesbaren Steuerinformationen, welche zumindest ein Computerprogramm nach Anspruch 12 umfassen und derart ausgestaltet sind, dass sie bei Verwendung des Datenträgers in einer Steuereinheit (5) nach einem der Ansprüche 1 bis 9 ein Verfahren nach Anspruch 10 durchführen.
